# EUROPEAN PATENT APPLICATION

(11) **EP 4 309 842 A1**
(43) Date of publication of application: **24.01.2024**
(21) Application number: 22771531.5
(22) Date of filing: 17.03.2022
(51) Int. Cl.: B24B 1/00, H01L 21/304

(54) **METHOD FOR MANUFACTURING GAAS WAFER, AND GAAS WAFER GROUP**

(30) Priority: 19.03.2021 JP 2021046569
(71) Applicant: DOWA Electronics Materials Co., Ltd., Tokyo 101-0021 (JP)
(72) Inventor: SUGIURA Junji, Tokyo 101-0021 (JP)
(74) Representative: Müller-Boré & Partner Patentanwälte PartG mbB
(86) International application number: PCT/JP2022/012469
(87) International publication number: WO 2022/196786

(57) **Abstract**

A method of producing a GaAs wafer having excellent OF orientation stability even in a GaAs wafer having an off angle, and a GaAs wafer group are provided. A method of producing a GaAs wafer includes: a grinding step of grinding a peripheral surface of a GaAs ingot including formation of a provisional orientation flat; a slicing step of slicing the GaAs ingot after the grinding step to cut out a material wafer having an off angle; and a cleaving step of applying marking to the material wafer according to an orientation of an orientation flat determined based on the provisional orientation flat and cleaving the material wafer toward a peripheral surface of the material wafer from the marking to form the orientation flat.

## Description

### TECHNICAL FIELD

This disclosure relates to a method of producing a GaAs wafer, and a GaAs wafer group obtained thereby, and particularly relates to a method of producing a GaAs wafer, in which an orientation flat is formed on a GaAs wafer having an off angle.

### BACKGROUND

In general, an orientation flat (hereinafter, referred to as an OF) that indicates the crystal orientation or the front and back of a wafer is formed on a peripheral surface of a semiconductor wafer, and the orientation flat is used as a mark to detect the disposition direction or the dicing direction of the semiconductor wafer when a semiconductor device is produced. Usually, the orientation flat is formed by cylindrically grinding a single crystal ingot, determining the orientation using an X-ray apparatus, and then surfacegrinding the single crystal ingot. Then, the surface-ground single crystal ingot is sliced to obtain a semiconductor wafer with the orientation flat.

Here, the orientation flat as a benchmark is required to be formed with high accuracy according to a desired crystal orientation, in a case where a semiconductor laser, in which the surface of the orientation flat is used as a resonant mirror, is produced or a case where a device produced with high density on a semiconductor wafer is chipped. As a method of thus forming the OF orientation with high accuracy, Patent Literature (PTL) 1 discloses that, on one surface of a semiconductor wafer on which a provisional orientation flat is formed, marking is formed roughly parallel to the provisional orientation flat, a part of the semiconductor wafer between the provisional orientation flat and the marking is inserted into a groove opening to the outer periphery of the edge of a cleavage jig, and the cleavage jig is rotated around the axis parallel to the provisional orientation flat to cleave the semiconductor wafer from the marking, thus forming an orientation flat.

### CITATION LIST

### Patent Literature

PTL 1: JP2006024839A

### SUMMARY

### (Technical Problem)

In a case where an epitaxial growth layer is formed on a wafer surface, a wafer having an off angle is used because good crystallinity can be achieved. The off angle indicates an angle at which the crystal orientation of the wafer surface is inclined with respect to the crystal orientation (for example, a (100) surface) used as an epitaxial growth face in the crystal structure of GaAs, that is zinc blende structure. The OF surface is perpendicular to the wafer surface in a wafer without off angle, while except for a particular case, the OF surface is not perpendicular to the wafer surface in a wafer having an off angle. This wafer having an off angle was more difficult to ensure the orientation accuracy of the orientation flat than the wafer without off angle. That is, in a wafer having a certain off angle, in particular, a GaAs wafer, it was difficult to stably form an orientation flat with high accuracy by the conventional method including the above-described technique disclosed in PTL 1. In the conventional method, there are variations in the orientation accuracy of the orientation flats between wafers. Thus, for example, in a case where a GaAs wafer group is made by cutting out a plurality of GaAs wafers from an identical GaAs ingot, it is inevitable that this GaAs wafer group includes wafers having an orientation flat with low orientation accuracy, resulting in bad product yield for the GaAs wafer group. Recently, the diameter of the GaAs wafer used in the production of LD (Laser Diode) devices has been increased. Particularly, when such a large-diameter wafer is produced, the orientation accuracy of the orientation flat when the wafer has an off angle was not good.

It could be helpful to provide a method of producing a GaAs wafer, which contributes to provide a GaAs wafer group in which an expected OF orientation appears with high accuracy even in a GaAs wafer having an off angle and variations in the OF orientation accuracy between wafers in an identical GaAs ingot can be decreased, that is, the OF orientation stability is excellent, and the GaAs wafer group.

### (Solution to Problem)

In order to solve the aforementioned problems, the inventor completed this disclosure as a result of intensive studies. That is, the main features of this disclosure are as described below.

The main features of this disclosure are as described below.
(1) A method of producing a GaAs wafer, comprising: a grinding step of grinding a peripheral surface of a GaAs ingot including formation of a provisional orientation flat; a slicing step of slicing the GaAs ingot after the grinding step to cut out a material wafer having an off angle; and a cleaving step of applying marking to the material wafer according to an orientation of an orientation flat determined based on the provisional orientation flat and cleaving the material wafer toward a peripheral surface of the material wafer from the marking to form the orientation flat, wherein the cleaving step is a step of cleaving the material wafer at a position where a length (interval A) of a line segment perpendicularly extended from the midpoint of the cleavage to the peripheral surface of the material wafer outward in a radial direction of the material wafer is 9 mm or more.
(2) The method of producing a GaAs wafer according to (1), wherein the interval A is 12 mm or more.
(3) The method of producing a GaAs wafer according to (1) or (2), wherein the off angle is 0.2° or more.
(4) The method of producing a GaAs wafer according to any one of (1) to (3), wherein an angle between a principal surface of the GaAs wafer and a surface forming the orientation flat is 89.8° or less or 90.2° or more.
(5) The method of producing a GaAs wafer according to any one of (1) to (4), wherein the GaAs wafer has a diameter of 100 mm or more.
(6) The method of producing a GaAs wafer according to any one of (1) to (4), wherein the GaAs wafer has a diameter of 150 mm or more.
(7) The method of producing a GaAs wafer according to any one of (1) to (6), further comprising a beveling step of beveling a peripheral surface of the GaAs wafer except for the orientation flat, after the cleaving step.
(8) A GaAs wafer group consisting of all GaAs wafers having an orientation flat after a step of cleaving the orientation flat, all GaAs wafers consisting of a plurality of GaAs wafers having an identical off angle obtained from an identical GaAs ingot, wherein the mean value of orientation flat orientation accuracies of the GaAs wafer group is within ±0.010°, and the standard deviation of the orientation flat orientation accuracies of the GaAs wafer group is 0.009° or less.
(9) The GaAs wafer group according to (8), wherein the off angle of the GaAs wafers is 0.2° or more.
(10) The GaAs wafer group according to (8) or (9), wherein an angle between a principal surface of the GaAs wafer and a surface forming the orientation flat is 89.8° or less or 90.2° or more.
(11) The GaAs wafer group according to any one of (8) to (10), wherein the mean value of the orientation flat orientation accuracies of the GaAs wafer group is within ±0.010°, and the standard deviation of the orientation flat orientation accuracies of the GaAs wafer group is 0.005° or less.
(12) The GaAs wafer group according to any one of (8) to (11), wherein the orientation flat orientation accuracies of the GaAs wafer group are within ±0.020°.
(13) The GaAs wafer group having an orientation flat according to any one of (8) to (12), wherein all of the GaAs wafers have diameters of 100 mm or more.
(14) The GaAs wafer group having an orientation flat according to any one of (8) to (12), wherein all of the GaAs wafers have diameters of 150 mm or more.

### (Advantageous Effect)

This disclosure can provide a method of producing a GaAs wafer, which contributes to provide a GaAs wafer group in which an expected OF orientation appears with high accuracy even in a GaAs wafer having an off angle and variations in the OF orientation accuracy between wafers in an identical GaAs ingot can be decreased, that is, the OF orientation stability is excellent. This disclosure can also provide a GaAs wafer group in which the mean value of OF orientation accuracies and the standard deviation of the OF orientation accuracies are both small.

### BRIEF DESCRIPTION OF THE DRAWINGS

In the accompanying drawings:
FIG. 1 is a drawing explaining a production flow;
FIG. 2A is a drawing explaining an angle between a principal surface of a GaAs wafer and a surface (OF surface) forming an orientation flat;
FIG. 2B is a drawing explaining an angle between a principal surface of a GaAs wafer and a surface (OF surface) forming an orientation flat;
FIG. 3 is a drawing explaining marking and cleavage in this example;
FIG. 4A is a drawing explaining a distance (interval A) between a peripheral surface of a GaAs wafer and an orientation flat;
FIG. 4B is a drawing explaining a distance (interval A) between a peripheral surface of a GaAs wafer and an orientation flat; and
FIG. 5 is a schematic view illustrating a state of measuring an OF orientation accuracy in this example.

### DETAILED DESCRIPTION

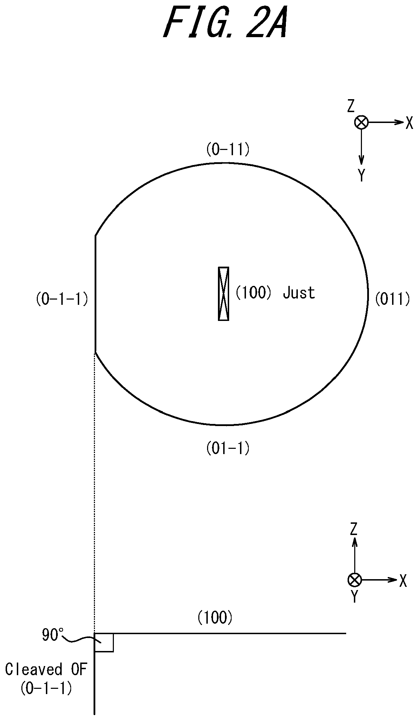

The following describes an embodiment of this disclosure with reference to the drawings. In FIG. 2A to FIG. 5, for simplicity, the size (length, thickness) of each component differs from the actual size, and some parts are exaggerated.

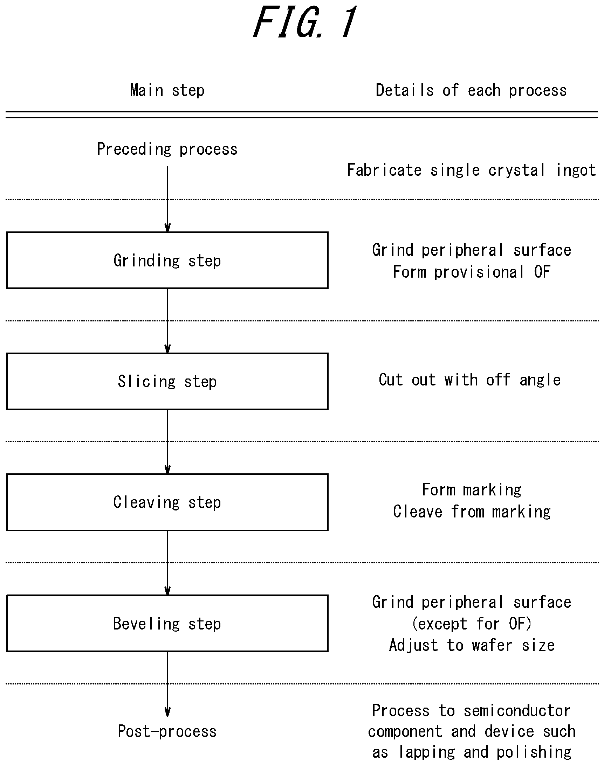

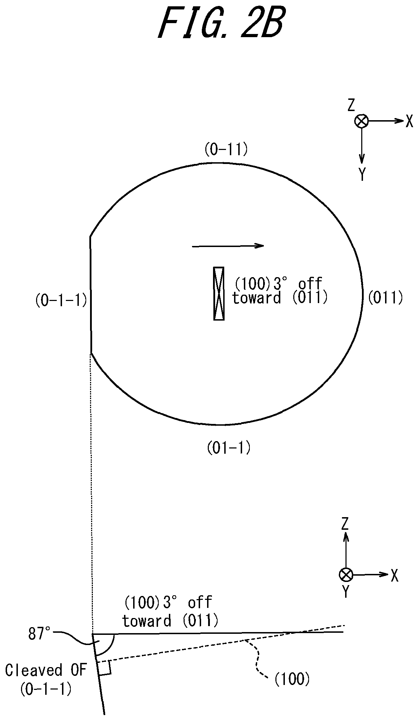

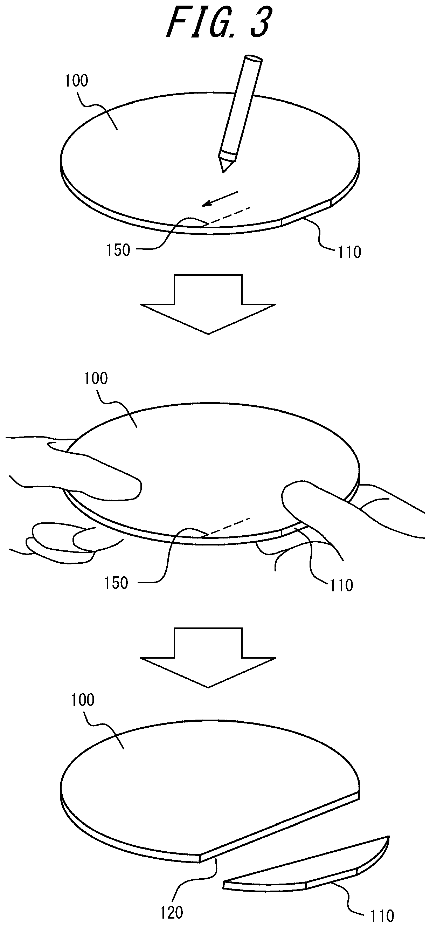

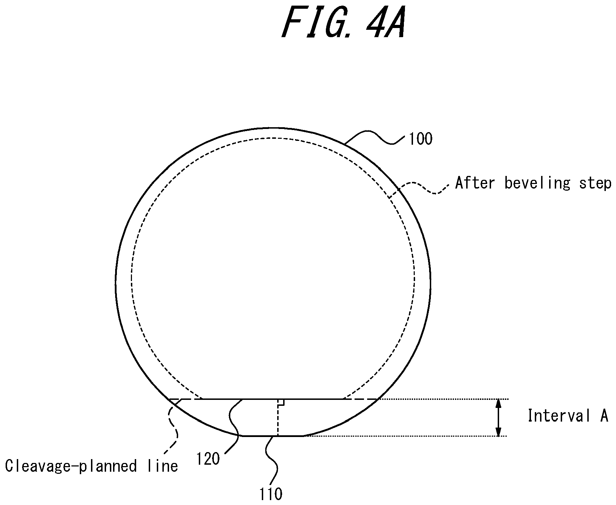

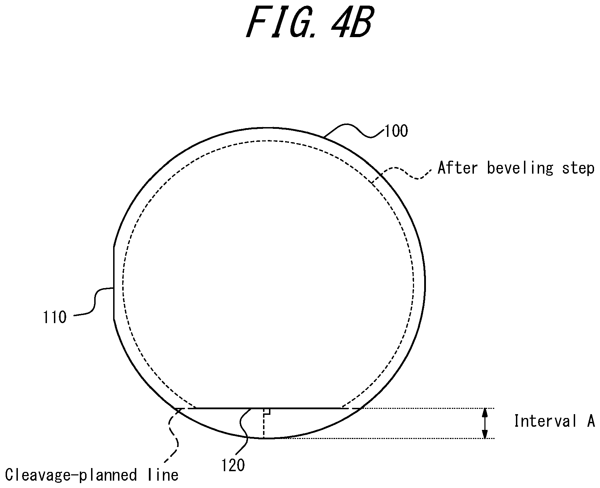

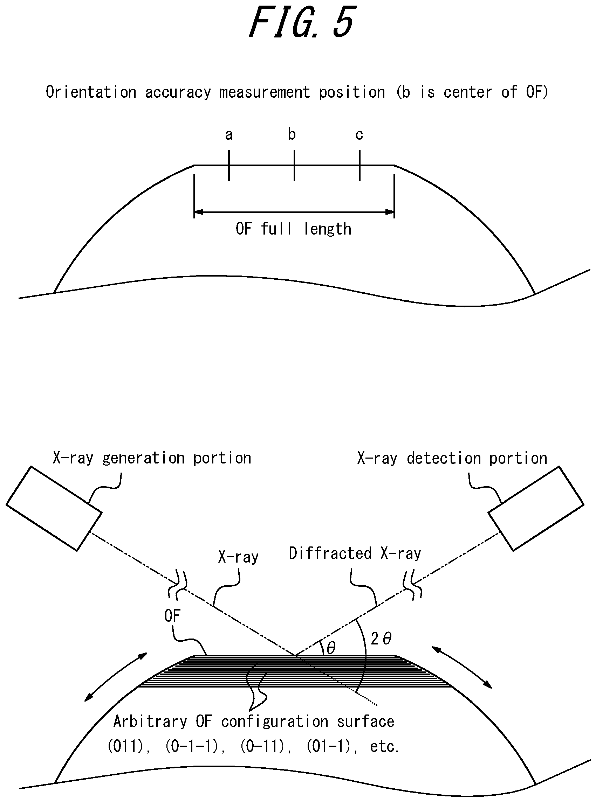

With reference to a production flow illustrated in FIG. 1, a method of producing a GaAs wafer according to one embodiment of this disclosure is described. This production method includes at least a grinding step of grinding a peripheral surface of a GaAs ingot including formation of a provisional orientation flat; a slicing step of slicing the GaAs ingot after the grinding step to cut out a material wafer having an off angle; and a cleaving step of applying marking to the material wafer according to an orientation of an orientation flat determined based on the provisional orientation flat, cleaving the material wafer toward a peripheral surface of the material wafer from the marking, and forming the orientation flat at a position where a length (interval A) of a line segment perpendicularly extended from the midpoint of the cleavage to the peripheral surface of the material wafer outward in a radial direction of the material wafer is 9 mm or more. The following describes the details of each step in sequence. FIG. 2A and FIG. 2B each illustrate an angle between a principal surface of a GaAs wafer and an orientation flat, FIG. 3 illustrates a method of forming an actual orientation flat, and FIG. 4A and FIG. 4B each illustrate a distance (interval A) from the midpoint of cleavage to the wafer peripheral surface, which is defined in this disclosure. FIG. 5 illustrates a method of measuring an OF orientation accuracy in this disclosure.

### (Grinding step)

First, a peripheral surface of a GaAs ingot produced by any method is ground to eliminate irregularities, and at the same time, a provisional orientation flat that indicates, for example, the crystal orientation is formed on the peripheral surface of the GaAs ingot. The grinding method is not particularly limited, but a method such as cylindrical grinding using a cylindrical grinder can be used for grinding the peripheral surface, and a method such as traverse grinding using a cylindrical grinder can be used for forming the provisional orientation flat.

### <GaAs ingot>

As a GaAs ingot for obtaining a GaAs wafer, a single crystal GaAs ingot obtained by any production method such as a pulling (LEC) method, a horizontal boat (HB) method, a vertical gradient freezing (VGF) method, and a vertical Bridgman (VB) method can be used. The diameter of the GaAs ingot is not limited, but, in this disclosure, it is preferably 10 mm or more than the diameter of a desired GaAs wafer to be finally obtained, to form an orientation flat having a certain interval from the peripheral surface of a material wafer.

### <Provisional orientation flat>

The provisional orientation flat may be an index of a relative position to the setting orientation of the orientation flat. Therefore, its orientation is not particularly limited, but it is preferably formed parallel or perpendicular to the setting orientation of the orientation flat.

### (Slicing step)

A plurality of material wafers is cut out from the GaAs ingot, on which the provisional orientation flat has been formed in the above grinding step, with a slicer such as a wire saw. At this time, the plurality of material wafers is sliced so as to have a certain off angle with respect to the growth direction of single crystal and have an identical off angle between the wafers to be cut out. The off angle can be arbitrarily set depending on the application of the wafer to the semiconductor component. The term "identical off angle" herein includes errors that are unavoidable at the production step and errors that are permissible to the extent that the operation and effect of this disclosure are produced.

### <Off angle>

As described above, the angle of the off angle is not particularly limited. However, for example, in a case where the GaAs wafer is used as the base of a laminated substrate, to improve the crystallinity of a layer to be grown on its upper portion, the off angle is preferably 0.2° or more, and more preferably 1° or more, and is preferably 15° or less. Here, the orientation of the off angle is not particularly limited so long as it is formed in an orientation other than horizontal to the orientation flat (orientation in which the angle between the principal surface of the wafer and the OF surface is not 90°). For example, in a case where the OF surface is a (0-1-1) surface as illustrated in FIG. 2A and FIG. 2B, the material wafer may have an off angle such that a (100) surface is inclined toward (011) (i.e., a perpendicular line <100> orthogonal to the (100) surface is inclined toward a <011> direction) or may have an off angle such that the (100) surface is inclined toward the (0-1-1) surface (i.e., the perpendicular line <100> orthogonal to the (100) surface is inclined toward a <0-1-1> direction). In FIG. 2A and FIG. 2B, in the case where the OF surface is the (0-1-1) surface, for example, when the material wafer has an off angle such that the (100) surface is inclined toward (0-11) or (01-1), the angle between the principal surface of the wafer and the OF surface remains 90° regardless of the off angle, and it is thus excluded the orientation of the off angle is an orientation horizontal to the orientation flat. The same applies to the case where the OF surface is a surface other than the (0-1-1) surface. The material wafer sliced to have a certain off angle exactly has an oval shape unlike the shape of a horizontal cross-section of the GaAs ingot before cutting out the material wafer. However, in the wafer size and off angle that are usually used, there is not such a size difference to affect the specification, even compared with a material wafer cut out without off angle.

### <Angle between principal surface of GaAs wafer and surface forming orientation flat>

When the principal surface of the GaAs wafer is the x-y plane and a direction vertical to the principal surface is the z-axis as illustrated in FIG. 2A and FIG. 2B, an angle between the principal surface of the GaAs wafer and a surface forming the orientation flat (hereinafter, referred to as the OF surface) is an angle between the principal surface of the GaAs wafer and the OF surface on the x-z cross-section in a case where the OF surface is parallel to the y-axis. For example, in the case where the OF surface is the (0-1-1) surface, when the above off angle is an angle of 0.2° from the (100) surface toward (011), that angle is 89.8°, and when the off angle is inclined toward the (0-1-1) surface, that angle is 90.2°. That angle is an angle formed due to the off angle, is an angle other than 90°, is preferably 75.0° or more and 89.8° or less, and is preferably 90.2° or more and 105.0° or less. Furthermore, that angle is more preferably 75.0° or more and 89.0° or less, or 91.0° or more and 105.0° or less. FIG. 2A illustrates that the angle between the principal surface of the wafer and the OF surface is 90° when there is no off angle (also referred to as just), and FIG. 2B illustrates that the angle between the principal surface of the wafer and the OF surface is 87° (93° when the off angle is inclined toward the (0-1-1) surface) when there is an off angle of 3° toward (011). It has been common general technical knowledge that the orientation stability of the orientation flat becomes worse as this angle between the principal surface of the wafer and the OF surface is separated from 90°. However, use of the production method of this disclosure can form an orientation flat having excellent orientation stability. The same applies to the case where the OF surface is a surface other than the (0-1-1) surface.

### (Cleaving step)

Next, the orientation flat is formed on the above material wafer. That is, as illustrated in FIG. 3, marking 150 that induces cleavage based on a provisional orientation flat 110 is applied to a material wafer 100, and the material wafer 100 is cleaved from the marking 150 to form an orientation flat 120. Here, the orientation in which the marking 150 is formed may be determined based on the relative positional relation with the provisional orientation flat 110 and may be any orientation such as (0-1-1), (0-11), (01-1), and (011) or may be another orientation. Specifically, after the marking 150 is formed, by applying force in an orientation of expanding the line of the marking 150, the cleavage propagates from the marking 150 to form a cleaved surface, thus forming the orientation flat 120. At this time, the marking 150 is formed such that the length of a line segment perpendicularly extended from the midpoint of the cleavage to a peripheral surface of the material wafer 100 outward in a radial direction of the material wafer 100 is 9 mm or more. In the actual work process, it is easier to understand for a worker that the provisional orientation flat 110 is parallel to the orientation flat 120 as illustrated in FIG. 4A. On the other hand, in a case where the provisional orientation flat 110 and the orientation flat 120 have a positional relation of 90° as illustrated in FIG. 4B, the region to be ground by beveling can be reduced. The formation of marking and the cleavage at the cleaving step can be performed using any instrument or production equipment.

### <Interval A>

The interval A in this disclosure is described by exemplifying FIG. 4A and FIG. 4B. First, in a case where the orientation flat 120 is formed in an orientation parallel to the provisional orientation flat 110 as in FIG. 4A, the length of the line segment perpendicularly extended from the midpoint of the cleavage to the peripheral surface of the material wafer 100 outward in the radial direction of the material wafer 100 is a length of the perpendicular line descending from the provisional orientation flat 110 to the orientation flat 120. In a case where the orientation flat 120 is formed in an orientation perpendicular to the provisional orientation flat 110 as in FIG. 4B, the camber when the cleavage is a chord is a length of the line segment perpendicularly extended from the midpoint of the cleavage to the peripheral surface of the material wafer 100 outward in the radial direction of the material wafer 100.

By setting this interval A to 9 mm or more, relatively uniform distortion occurs on a surface on which the orientation flat is formed. Thus, a fracture surface formed such that the cleavage propagates from the marking is formed along a crystal plane. A larger interval A stabilizes the OF orientation accuracy, and the interval A is thus preferably 12 mm or more. In terms of effective use of the wafer, the interval A is preferably30 mm or less and further preferably 25 mm or less. On the other hand, when the interval A is less than 9 mm, in a cleavage-planned surface, it is difficult to generate relatively uniform distortion on the surface on which the orientation flat is formed and the direction in which the cleavage propagates is difficult to be determined, and the fracture surface to be formed thus becomes an orientation flat having bad OF orientation accuracy.

### (Beveling step)

In the material wafer on which the orientation flat has been formed, the wafer edge may be ground by subjecting the peripheral surface to beveling using a grindstone to shape the edge. Chamfering is applied to the peripheral surface of the wafer by beveling, which can prevent cracking in the subsequent processes and shape the diameter of the wafer to a predetermined size. On the orientation flat formed by cleavage in this disclosure, an expected crystal plane is exposed with high accuracy, which needs to avoid beveling.

The application of the GaAs wafer fabricated through the above-described steps is not particularly limited. However, its diameter is preferably 100 mm or more and further preferably 150 mm or more so that the GaAs wafer can be used for producing a variety of electronic devices, light emitting devices, LD (Laser Diode) devices, etc. Particularly, when the diameter of the GaAs wafer is 150 mm or more, it was difficult to achieve excellent OF orientation accuracy for the orientation flat, but high OF orientation accuracy can be achieved in this disclosure. The orientation flat is accurately formed along the crystal plane at the cleaving step, which causes this orientation flat to have excellent OF orientation accuracy. Therefore, by processing all of the material wafers cut out from an identical GaAs ingot according to this production method, in all of the GaAs wafers after the cleaving step, which are fabricated from the identical GaAs ingot and obtained as a GaAs wafer group, the mean value of the OF orientation accuracies is within ±0.010°, and the standard deviation of the OF orientation accuracies is 0.009° or less.

Next, the GaAs wafer group obtained using the above production method is described.

The GaAs wafer group of this disclosure is consisting of all GaAs wafers having an orientation flat after the cleaving step of the orientation flat, and the all GaAs wafers are consisting of GaAs wafers having an identical off angle obtained from an identical GaAs ingot. The mean value of the OF orientation accuracies of the GaAs wafer group is within ±0.010°, and the standard deviation of the OF orientation accuracies of the GaAs wafer group is 0.009° or less. The angle of the off angle of the GaAs wafer is not particularly limited. However, for example, in a case where the GaAs wafer is used as the base of a laminated substrate, to improve the crystallinity of a layer to be grown on its upper portion, the off angle is preferably 0.2° or more, and more preferably 1° or more, and is preferably 15° or less. The angle between the principal surface of the GaAs wafer and the OF surface is preferably 89.8° or less, or 90.2° or more. The application of the GaAs wafer group of this disclosure is not particularly limited. However, its diameter is preferably 100 mm or more and further preferably 150 mm or more so that the GaAs wafer group can be used for producing a variety of electronic devices, light emitting devices, LD (Laser Diode) devices, etc.

### <OF orientation accuracy and standard deviation thereof>

The OF orientation accuracy herein is the deviation from the crystal plane on which the orientation flat was to be formed, which is indicated as an angle (°) by X-ray diffraction method. At this time, in one wafer, as described in examples below and FIG. 5, the OF orientation accuracy was measured at three predetermined positions on the orientation flat (the center of the orientation flat and positions separated from the center by about 30% to 46% of the OF full length). Furthermore, the standard deviation of all measurement values of a plurality of wafers was determined. In the following examples, the measurement is performed on a plurality of representative wafers pulled out at even intervals from an ingot. However, for measurement of the OF orientation accuracies of the GaAs wafer group, the measurement is preferably performed on all GaAs wafers after the cleaving step of the orientation flat in an identical GaAs ingot. The measurement of the OF orientation accuracies in the GaAs wafer group is preferably performed on 50 or more wafers. For the above OF orientation accuracies and the standard deviation thereof, in the GaAs wafer group fabricated according to the above-described production method of this disclosure, the mean value of the OF orientation accuracies (all measurement values) is within ±0.010°, and the standard deviation of the OF orientation accuracies is 0.009° or less. The standard deviation of the OF orientation accuracies is more preferably 0.005° or less. A smaller standard deviation of the OF orientation accuracies reduces the variations of the OF orientation accuracies among the wafers in the ingot, which reduces the possibility that the measurement position where the OF orientation accuracy exceeds ±0.020° is generated.

Here, when the OF orientation accuracy is not good, this OF orientation accuracy is also reflected in a case where the wafer is processed to produce a semiconductor component. The OF orientation accuracies of all wafers required for SEMI standard, one of the standard specifications regarding the semiconducting device are ±0.5°. However, in a case where the orientation flat is formed by cleavage, a stricter standard value is required, and to the inventor's knowledge, a standard value within ±0.020° is required. In a plurality of wafers fabricated from an identical GaAs ingot, wafers without good OF orientation accuracy are fabricated to no small extent. Thus, the product yield of the wafers that comply with the above standard is also an important index. From the reasons as described above, in the GaAs wafer group of this disclosure, it is required that the mean value of the OF orientation accuracies is within ±0.010° and the standard deviation of the OF orientation accuracies is 0.009° or less. It is preferable that the double range of the standard deviation (σ) from the mean value of the respective measurement values of the OF orientation accuracy (from the mean value - 2σ to the mean value + 2σ) falls within ±0.020°. When the double range of the standard deviation from the mean value of the respective measurement values is within ±0.020°, there are a few variations in the OF orientation accuracy, and the yield is improved relative to the standard value within ±0.020°, which can decrease the number of the wafers that cannot be products. Therefore, it is more preferable that the mean value of the OF orientation accuracies of the GaAs wafer group is within ±0.010° and the standard deviation of the OF orientation accuracies is 0.005° or less.

### EXAMPLES

The following describes the details of the method of producing a GaAs wafer according to this disclosure using examples.

### (Example 1)

A single crystal GaAs ingot with a diameter of 164.0 mm was prepared, a cone portion and a tail portion were cut with an inner peripheral blade slicer, and the GaAs ingot was ground by cylindrical grinding to have a diameter of 161.5 mm.

Then, the orientation of (0-1-1) of the cylindrically ground GaAs ingot was determined using an X-ray apparatus ("GaAs ingot orientation flat surface measurement device GaAs-GOX (TSKK Ver.)" made by Rigaku Corporation, which is mounted on a cylindrical grinder (CSN-7015 NC cylindrical grinder (NC 3-axis) made by TOKYO SEIKI KOSAKUSHO Co., Ltd.), and the GaAs ingot was then subject to traverse grinding to form a provisional orientation flat with a length 15 mm.

Next, from the GaAs ingot after the grinding step, a material wafer with a thickness of 785 µm was cut out by slicing using a wire saw so that the wafer cut out from the GaAs ingot has an off angle of 3° from the (100) surface toward the (011) direction.

Marking that induces cleavage for orientation flat parallel to the provisional orientation flat was applied to the material wafer, and the material wafer was then cleaved from this marking to form an orientation flat at a position where the interval (interval A) between the orientation flat and the provisional orientation flat was 12 mm. The marking was formed with a marking pen with a pointed top, the marking position was a peripheral surface of the wafer at one side of a cleavage-planned line of the wafer, and the marking length was 4 mm.

Then, by holding the edge of the wafer, to which the marking had been applied, by hand and applying force to expand the marking, the wafer was cleaved to form the orientation flat. Subsequently, the wafer outer periphery except for a part with a width of about 50 mm at the center of the cleaved orientation flat surface was subjected to the beveling step to form a wafer with a diameter of 150 mm, thus obtaining a GaAs wafer group of Example 1. The above marking position is a position to be scraped at the beveling step.

For each wafer of the obtained GaAs wafer group, the OF orientation accuracy at each position of measurement positions a to c illustrated in FIG. 5 was determined by X-ray diffraction measurement. The above measurement was performed on total five representative wafers obtained by selecting one at even intervals for each 20 from total 102 wafers that constitute the GaAs wafer group obtained after the cleaving step, except for a few wafers pulled out for inspection before the cleaving step. Table 1 represents the measurement results. In the five wafers of Example 1, the OF orientation accuracies were all within ±0.020°, their mean value was 0.000°, and the standard deviation was also small, 0.002°. The double range of the standard deviation from the mean value was ±0.004°, from which it was expected that the yield was good in all wafers that constitute the GaAs wafer group. When the OF orientation accuracies were measured for total 102 wafers that constitute the GaAs wafer group after the cleaving step, the OF orientation accuracies fell within ±0.020° at all measurement positions in all wafers, and the yield of the orientation accuracy at the cleaving step with respect to the standard value within ±0.020° was 100%. The mean value of the OF orientation accuracies at all measurement positions in all wafers was within ±0.010°, and the standard deviation of the OF orientation accuracies was 0.005° or less.

### <Method of measuring OF orientation accuracy>

The evaluation of the OF orientation accuracy in Example 1 was performed as follows. For the obtained GaAs wafer, the OF orientation accuracy (°) with respect to a planned OF crystal plane (0-1-1) was determined by X-ray diffraction measurement (2991F2 made by Rigaku Corporation). Specifically, as illustrated in FIG. 5, while the OF surface was irradiated with X-ray, the wafer was arbitrarily rotated in a black arrow direction with reference to the OF surface. Then, by comparing rotation angles at which Bragg diffraction occurred with respect to the crystal plane of the planned OF surface, the amount of deviation of the crystal plane from the physical plane was computed and set as the OF orientation accuracy. For example, when the plane direction of the OF surface is (0-1-1), θ = 22.5°, and 2θ = 45°. Thus, the OF orientation accuracy is an amount of deviation from this angle. The OF full length in Example 1 was about 50 mm. Total three positions of the center (b in FIG. 5) of the OF and points each away from the center of the OF by 20 mm (a and c in FIG. 5) were set to the measurement positions of the OF orientation accuracy.

### (Example 2)

GaAs wafers were fabricated in the same way as in Example 1, except that marking was formed such that the interval A was 10 mm, and the OF orientation accuracies of the obtained orientation flats were measured for five representative wafers.

### (Example 3)

GaAs wafers were fabricated in the same way as in Example 1, except that marking was formed such that the interval A was 9 mm, and the OF orientation accuracies of the obtained orientation flats were measured for five representative wafers.

### (Comparative Example 1)

By selecting one at even intervals for each 50 wafers from the obtained group of 102 GaAs wafers, the measurement was performed on total three representative wafers. GaAs wafers were fabricated in the same way as in Example 1, except that marking was formed such that the interval A was 8 mm, and the OF orientation accuracies of the obtained orientation flats were measured.

### (Comparative Example 2)

By selecting one at even intervals for each 50 wafers from the obtained group of 102 GaAs wafers, the measurement was performed on total three representative wafers. GaAs wafers were fabricated in the same way as in Example 1, except that marking was formed such that the interval A was 6 mm, and the OF orientation accuracies of the obtained orientation flats were measured.

**[Table 1]**

| | Interval A (mm) | Sample No. | OF orientation accuracy (°) | | | | |
|---|---|---|---|---|---|---|---|
| | | | Measurement position a | Measurement position b | Measurement position c | Mean value | Standard deviation |
| Example 1 | 12 | 1-1 | -0.002 | 0.001 | 0.003 | 0.000 | 0.002 |
| | | 1-2 | -0.003 | -0.001 | -0.001 | | |
| | | 1-3 | -0.001 | -0.002 | -0.001 | | |
| | | 1-4 | -0.002 | -0.002 | 0.003 | | |
| | | 1-5 | -0.002 | -0.001 | 0.003 | | |
| Example 2 | 10 | 2-1 | 0.007 | 0.006 | 0.004 | 0.002 | 0.005 |
| | | 2-2 | 0.013 | 0.007 | 0.003 | | |
| | | 2-3 | 0.008 | -0.004 | -0.007 | | |
| | | 2-4 | 0.003 | -0.003 | 0.001 | | |
| | | 2-5 | 0.001 | -0.003 | -0.001 | | |
| Example 3 | 9 | 3-1 | 0.004 | 0.009 | -0.010 | -0.001 | 0.005 |
| | | 3-2 | -0.002 | 0.002 | -0.004 | | |
| | | 3-3 | 0.001 | 0.003 | -0.005 | | |
| | | 3-4 | -0.005 | 0.003 | -0.004 | | |
| | | 3-5 | -0.004 | 0.004 | -0.003 | | |
| Comparative Example 1 | 8 | 4-1 | 0.003 | 0.008 | -0.412 | -0.052 | 0.138 |
| | | 4-2 | 0.013 | 0.014 | -0.078 | | |
| | | 4-3 | 0.004 | -0.005 | -0.016 | | |
| Comparative Example 2 | 6 | 5-1 | 0.012 | 0.009 | -0.400 | -0.068 | 0.135 |
| | | 5-2 | 0.016 | -0.101 | -0.125 | | |
| | | 5-3 | 0.003 | 0.009 | -0.038 | | |

As represented in Table 1, in Comparative Examples 1 and 2, there were measurement values in which the OF orientation accuracies exceeded ±0.020°, the variations were large, and the standard deviation was also large. In Examples 1 to 3, there is no measurement value in which the OF orientation accuracies exceeded ±0.020°, the mean value was within ±0.010°, and the standard deviation was 0.005° or less, and the variations were thus small.

### REFERENCE SIGNS LIST

- 100: material wafer
- 110: provisional orientation flat
- 120: orientation flat
- 150: marking

## Claims

1. A method of producing a GaAs wafer, comprising:
a grinding step of grinding a peripheral surface of a GaAs ingot including formation of a provisional orientation flat;
a slicing step of slicing the GaAs ingot after the grinding step to cut out a material wafer having an off angle; and
a cleaving step of applying marking to the material wafer according to an orientation of an orientation flat determined based on the provisional orientation flat and cleaving the material wafer toward a peripheral surface of the material wafer from the marking to form the orientation flat,
wherein the cleaving step is a step of cleaving the material wafer at a position where a length (interval A) of a line segment perpendicularly extended from the midpoint of a cleavage to the peripheral surface of the material wafer outward in a radial direction of the material wafer is 9 mm or more.

2. The method of producing a GaAs wafer according to claim 1, wherein the interval A is 12 mm or more.

3. The method of producing a GaAs wafer according to claim 1 or 2, wherein the off angle is 0.2° or more.

4. The method of producing a GaAs wafer according to any one of claims 1 to 3, wherein an angle between a principal surface of the GaAs wafer and a surface forming the orientation flat is 89.8° or less or 90.2° or more.

5. The method of producing a GaAs wafer according to any one of claims 1 to 4, wherein the GaAs wafer has a diameter of 100 mm or more.

6. The method of producing a GaAs wafer according to any one of claims 1 to 4, wherein the GaAs wafer has a diameter of 150 mm or more.

7. The method of producing a GaAs wafer according to any one of claims 1 to 6, further comprising a beveling step of beveling a peripheral surface of the GaAs wafer except for the orientation flat, after the cleaving step.

8. A GaAs wafer group consisting of all GaAs wafers having an orientation flat after a step of cleaving the orientation flat, all GaAs wafers consisting of a plurality of GaAs wafers having an identical off angle obtained from an identical GaAs ingot,
wherein the mean value of orientation flat orientation accuracies of the GaAs wafer group is within ±0.010°, and the standard deviation of the orientation flat orientation accuracies of the GaAs wafer group is 0.009° or less.

9. The GaAs wafer group according to claim 8, wherein the off angle is 0.2° or more.

10. The GaAs wafer group according to claim 8 or 9, wherein an angle between a principal surface of the GaAs wafer and a surface forming the orientation flat is 89.8° or less or 90.2° or more.

11. The GaAs wafer group according to any one of claims 8 to 10, wherein the mean value of the orientation flat orientation accuracies of the GaAs wafer group is within ±0.010°, and the standard deviation of the orientation flat orientation accuracies of the GaAs wafer group is 0.005° or less.

12. The GaAs wafer group according to any one of claims 8 to 11, wherein the orientation flat orientation accuracies of the GaAs wafer group are within ±0.020°.

13. The GaAs wafer group according to any one of claims 8 to 12, wherein all of the GaAs wafers have diameters of 100 mm or more.

14. The GaAs wafer group according to any one of claims 8 to 12, wherein all of the GaAs wafers have diameters of 150 mm or more.
